Europäisches Patentamt

European Patent Office

Office européen des brevets

(11) Veröffentlichungsnummer: **0 226 042**

**A2**

(12) # EUROPÄISCHE PATENTANMELDUNG

(21) Anmeldenummer: **86115678.4**

(51) Int. Cl.⁴: **H05K 7/12**

(22) Anmeldetag: **12.11.86**

(30) Priorität: **04.12.85 DE 3542914**
**03.10.86 DE 3633625**

(43) Veröffentlichungstag der Anmeldung:
**24.06.87 Patentblatt 87/26**

(84) Benannte Vertragsstaaten:
**DE FR GB IT**

(71) Anmelder: **VDO Adolf Schindling AG**
**Gräfstrasse 103**
**D-6000 Frankfurt/Main(DE)**

(72) Erfinder: **Eisenblätter, Axel**
**Am Frankenhag 7**
**D-6500 Mainz 7(DE)**
Erfinder: **Sonnack, Gerhard**
**Schollengasse 7**
**D-5307 Wachtberg(DE)**
Erfinder: **Hörning, Günter**
**Im Stückes 65**
**D-6233 Kelkheim(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Trägerplatte.**

(57) Eine Trägerplatte (1) aus Metall hat zumindest eine Aufnahmevertiefung (10), in die ein elektronisches Bauteil (4 ) mit einem Sockel (12) aus Kupfer eingesetzt ist. Gehalten wird das Bauteil (4) durch Halteteile (13, 14), die außenseitig am Sockel (12) hochgeführt sind und mit Abbiegungen (15, 16) über den Sockel (12) greifen.

Fig. 2

## Trägerplatte

Die Erfindung bezieht sich auf eine aus Metall bestehende Trägerplatte, auf der mehrere elektronische Bauteile, insbesondere IC's, mit jeweils einem metallischen Sockel aufgesetzt und gehalten sind. Solche Trägerplatten werden für den Aufbau elektronischer Schaltungen allgemein verwendet und sind daher bekannt.

Üblicherweise bestehen die Trägerplatten aus Aluminium und die Sockel aus Kupfer. Die die Sockel aus Kupfer aufweisenden, elektronischen Bauteile sitzen auf den Trägerplatten, damit in den elektronischen Bauteilen entstehende Wärme gut abgeleitet werden kann. Die Sockel der elektronischen Bauteile sind bei den bekannten Trägerplatten auf diese aufgelötet. Hierzu müssen die Trägerplatten vernickelt sein.

Die elektronischen Bauteile sind auf den Trägerplatten mit anderen elektronischen Bauteilen verbunden. Ein Testen der Bauteile ist erst möglich, wenn diese komplett montiert sind. Erweist sich dann ein Bauteil als defekt, so muß es ausgewechselt werden. Hierzu muß es abgelötet werden, was wegen der Verlötung des Sockels mit der Trägerplatte eine erhebliche Wärmezufuhr verlangt. Das führt dazu, daß sich benachbarte elektronische Bauteile ebenfalls ablöten und dadurch unbrauchbar werden. Deshalb ist auch zu Reparaturzwecken ein Auswechseln einzel ner, elektronischer Bauteile nicht möglich.

Der Erfindung liegt die Aufgabe zugrunde, eine Trägerplatte der eingangs genannten Art derart zu gestalten, daß auch nach der kompletten Montage aller Bauelemente die einzelnen Bauelemente ausgewechselt werden können, ohne daß dabei benachbarte Bauelemente beschädigt werden.

Diese Aufgabe wird erfindungsgemäß dadurch gelöst, daß die Sockel der elektronischen Bauteile durch teilweise über die Sockel greifende Halteteile der Trägerplatte auf ihr lösbar gehalten sind.

Bei dieser Gestaltung verzichtet man auf das Auflöten der Sockel der elektronischen Bauteile auf die Trägerplatte. Dadurch können die elektronischen Bauteile nach ihrer Montage ohne Wärmezufuhr von der Trägerplatte abgehoben werden. Das ermöglicht einen Austausch einzelner Bauteile, wenn sich diese beim Durchmessen einer Schaltung als defekt erweisen oder wenn sie im Laufe der Zeit defekt werden. Dank der Erfindung wird deshalb die Herstellung und Reparatur elektronischer Schaltungen billiger.

Die von den elektronischen Bauteilen in die Sockel fließende Wärme kann besonders gut in die Trägerplatten geleitet werden, wenn die Sockel der elektronischen Bauteile in Aufnahmevertiefungen der Trägerplatte eingesetzt sind. Außerdem werden die Sockel in diesen Aufnahmevertiefungen zusätzlich gegen ein seitliches Verschieben gesichert.

Besonders kostengünstig können die Aufnahmevertiefungen durch Formpressen erzeugt werden.

Besonders einfach sind die Sockel auf der Trägerplatte bzw. in den in ihr vorhandenen Aufnahmevertiefungen gehalten, wenn gemäß einer vorteilhaften Ausgestaltung der Erfindung die Halteteile durch aus der Ebene der Halteplatte ragende Stege gebildet sind, welche mit jeweils zumindest einer Abbiegung teilweise über die Sockel greifen.

In Aufnahmevertiefungen einer einheitlichen Breite können elektronische Bauteile verschiedener Breite eingesetzt werden, wenn die Aufnahmevertiefungen breiter als die Sockel sind und in ihnen zumindest ein Halteteil eingesetzt ist, welcher den aus der Ebene der Halteplatte ragenden Steg aufweist.

Besonders leicht auswechselbar sind die elektronischen Bauteile, wenn die Halteteile in die Trägerplatte eingesetzte Federelemente sind, welche mit einem Federarm federnd teilweise über zumindest einen Sockel ragen.

Zur Verminderung der Herstellungskosten elektronischer Schaltungen trägt es bei, wenn gemäß einer anderen Ausgestaltung der Erfindung die Federelemente durch in entgegengesetzte Richtungen weisende Federarme zum Halten von jeweils zwei Sockeln augebildet sind.

Der Kontakt der Sockel der elektronischen Bauteile mit der Trägerplatte kann dadurch verbessert werden, daß zwischen den Sockeln und der Trägerplatte eine Wärmeleitpaste vorgesehen ist. Dadurch verringert sich der Wärmeübergangswiderstand zwischen den Sockeln und der Trägerplatte.

Weitere vorteilhafte Ausführungsformen sind in den übrigen Unteransprüchen gekennzeichnet. Ihre jeweiligen Vorteile ergeben sich aus den nachfolgenden Figurenbeschreibungen.

Die Erfindung läßt zahlreiche Ausführungsformen zu. Zur weiteren Verdeutlichung ihres Grundprinzips sind mehrere davon in der Zeichnung dargestellt und werden nachfolgend beschrieben. Die Zeichnung zeigt in

Fig. 1 eine schematische Draufsicht auf eine erfindungsgemäß gestaltete Trägerplatte mit elektronischen Bauteilen,

Fig. 2 eine Schnittdarstellung durch die Trägerplatte im Bereich eines elektronischen Bauteils,

Fig. 3 eine Draufsicht auf die Anordnung nach der Figur 2,

Fig. 4 eine Schnittdarstellung durch eine zweite Ausführungsform einer Trägerplatte mit zwei elektronischen Bauteilen,

Fig. 5 eine Draufsicht auf die Anordnung nach der Figur 4,

Fig. 6 eine räumliche Ansicht einer weiteren Ausführungsform einer Trägerplatte mit einem elektronischen Bauteil,

Fig. 7 eine Draufsicht auf eine weitere Ausführungsform einer Trägerplatte mit einem elektronischen Bauteil,

Fig. 8 einen Schnitt durch die Anordnung nach Figur 7,

Fig. 9 eine Draufsicht auf eine weitere Ausführungsform einer Trägerplatte mit einem elektronischen Bauteil,

Fig. 10 einen Schnitt durch die Anordnung nach Figur 9,

Fig. 11 eine räumliche Ansicht einer weiteren Ausführungsform einer Trägerplatte mit einem elektronischen Bauteil,

Fig. 12 einen Schnitt durch eine Trägerplatte mit einem noch nicht darauf befestigten elektronischen Bauteil,

Fig. 13 eine der Figur 12 entsprechende Darstellung mit einem befestigten, elektronischen Bauteil,

Fig. 14 einen Schnitt durch einen gegenüber Figur 12 erweiterten Bereich einer Trägerplatte,

Fig. 15 eine Draufsicht auf die Anordnung nach Fig. 14,

Fig. 16 einen Schnitt durch eine weitere Ausführungsform einer Trägerplatte mit einem elektronischen Bauteil,

Fig. 17 einen Schnitt durch eine abgeänderte Ausführungsform einer Trägerplatte mit einem elektronischen Bauteil,

Fig. 18 eine Draufsicht auf die Anordnung nach Figur 17.

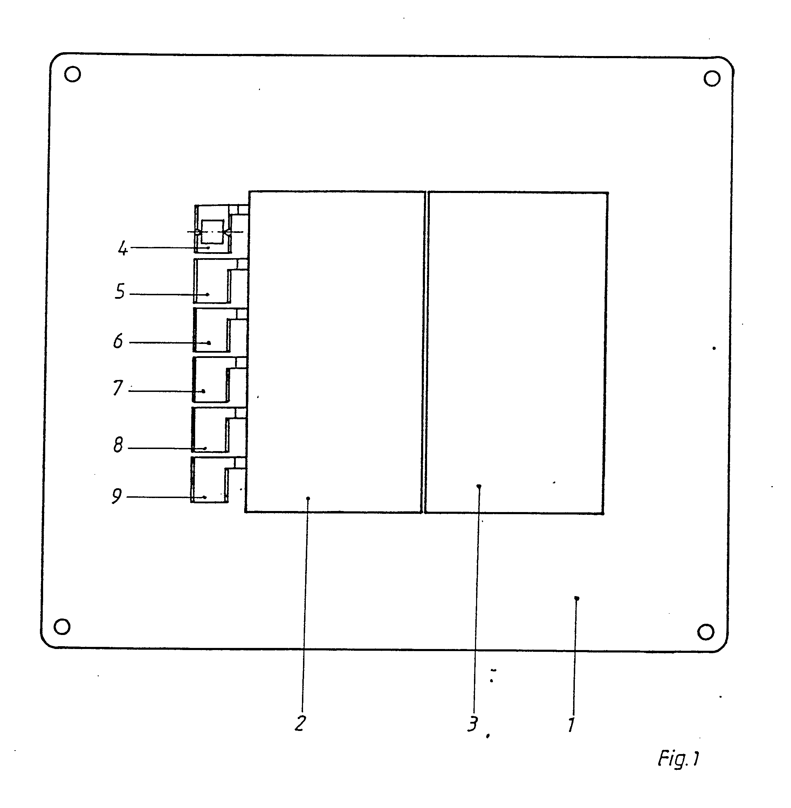

Die Figur 1 zeigt eine Trägerplatte 1, die üblicherweise aus Aluminium besteht, damit sie gut wärmeleitend ist. Auf dieser Trägerplatte sind zwei Hybride 2, 3 angeordnet. In der Zeichnung gesehen links vor diesen Hybriden 2, 3 befinden sich sechs elektronische Bauteile, von denen nur ein Bauteil 4 dargestellt ist. Bei diesen Bauteilen 4 handelt es sich um Leistungs-IC's. Unterhalb des elektronischen Bauteils 4 sind nebeneinander fünf Aufnahmevertiefungen 5 -9 gezeigt, die zur Aufnahme der elektronischen Bauteile dienen. Nicht dargestellt ist, daß die elektronischen Bauteile 4 mit dem Hybrid 2 und mit weiteren Bauteilen verdrahtet sind.

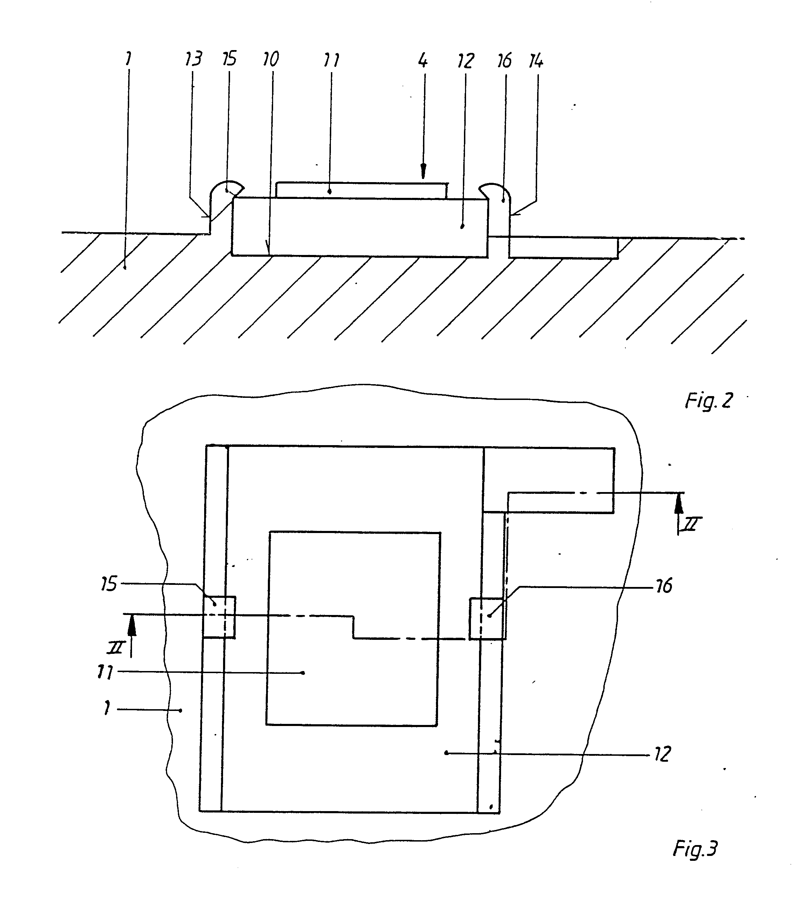

Die Figur 2 zeigt einen Teilbereich der Trägerplatte 1. Diese weist eine Aufnahmevertiefung 10 auf, in der das elektronische Bauteil 4 sitzt. Dieses elektronische Bauteil besteht aus einem Chip 11, welches auf einem Sockel 12 aus Kupfer aufgebracht ist. Dieser Sockel 12 steht fest in der Aufnahmevertiefung 10. An beiden Längsseiten der Sockel 12 sind Halteteile 13, 14 vorgesehen, die an den Längsseiten des Sockels 12 hochgeführt sind und jeweils mit einer Abbiegung 15, 16 teilweise über den Sockel 14 greifen.

Die Figur 3 läßt erkennen, daß diese Abbiegungen 15, 16 relativ schmal sind und nicht über die gesamte Länge des Sockels 12 reichen.

Die Aufnahmevertiefung 10 wird vorzugsweise durch Formpressen erzeugt. Das Halteteil 13 bildet dann eine Einheit mit der Trägerplatte 1. Die Halteteile 13 und 14 bilden dann eine Einheit mit der Trägerplatte 1.

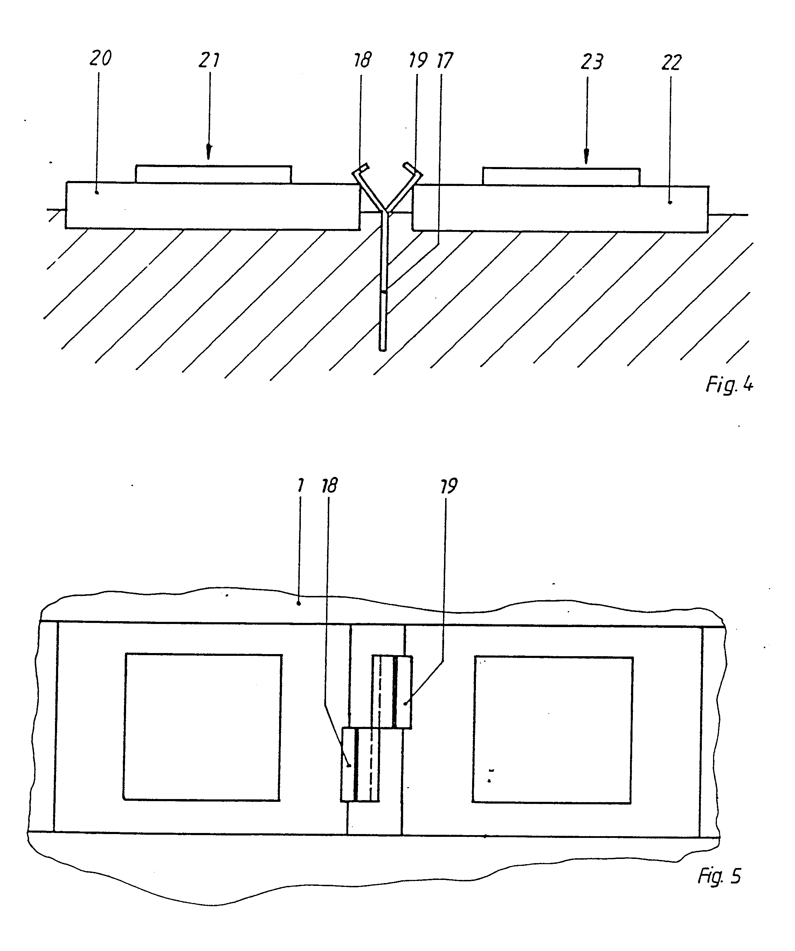

Die Ausführungsform gemäß den Figuren 4 und 5 zeigt als Halteteil ein Federelement 17, welches in die Trägerplatte 1 eingesetzt ist und zwei Federarme 18, 19 hat, die in entgegengesetzte Richtungen weisen. Dadurch ist ein Federarm 18 in der Lage, sich auf einen Sockel 20 eines elektronischen Bauteils 21 und der andere Federarm 19 sich auf einen Sockel 22 eines benachbarten elektronischen Bauteils 23 aufzusetzen.

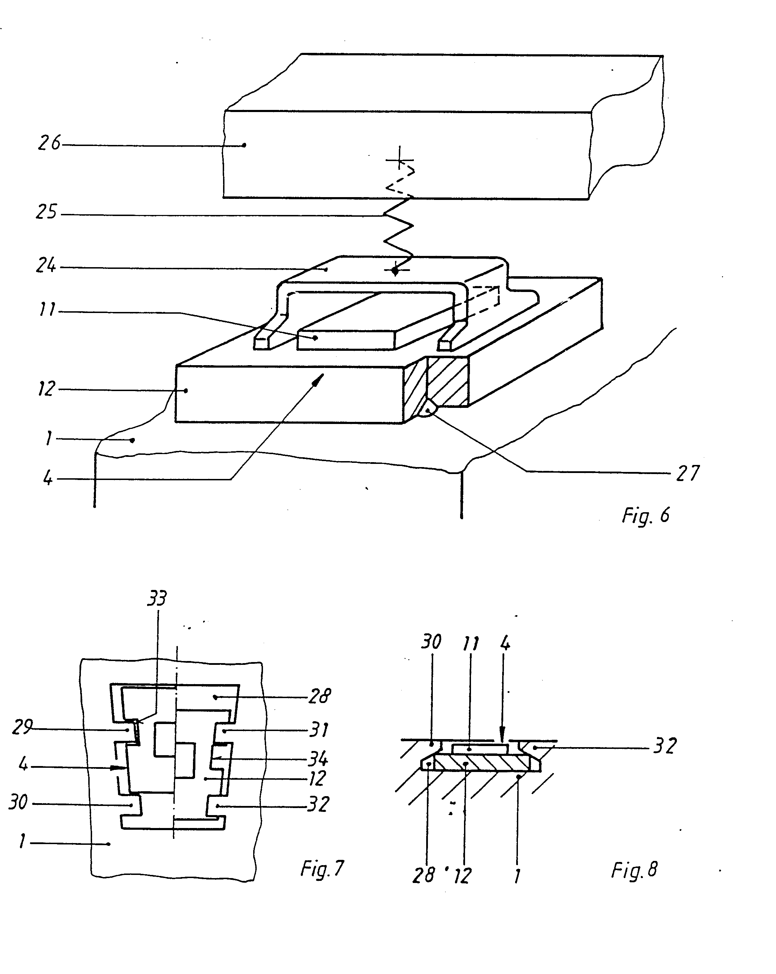

Gemäß Figur 6 ist das elektronische Bauteil 4 mittels eines brückenartigen Druckstückes 24 auf der Trägerplatte lösbar gehalten. Hierzu greift das Druckstück 24 über das Chip 11 und stützt sich beiderseits des Chips 11 auf dem Sockel 12 ab. Eine Druckfeder 25, welche zwischen der Oberseite des Druckstückes 24 und einem Balken 26 gespannt ist, erzeugt die erforderliche Anpreßkraft des Druckstückes 24. Der Balken 26 ist seinerseits in Freiräumen zwischen den elektronischen Bauteilen 4 lösbar befestigt, was jedoch nicht dargestellt wurde. Er kann entweder alle elektronischen Bauteile überspannen, oder jeweils für ein einzelnes Bauteil ausgebildet sein.

Die Figuren 7 und 8 zeigen in der Trägerplatte 1 eine trapezförmige Wanne 28, in der ein entsprechend trapezförmiger Sockel 12 mit dem Chip 11 eingesetzt ist. Gehalten wird dieser Sockel 12 durch Pratzen 29 - 32, die von der Seite her über den Sockel 12 greifen. Seitliche Aussparungen 33, 34 im Sockel 12 ermöglichen es, den Sockel 12 in die Wanne 28 einzusetzen, was im linken Teil der Figur 7 gezeigt ist, und dann so weit zu verschieben, bis daß die Pratzen 29 -32 über den Sockel 12 greifen, und das elektronische Bauteil 4 dadurch halten.

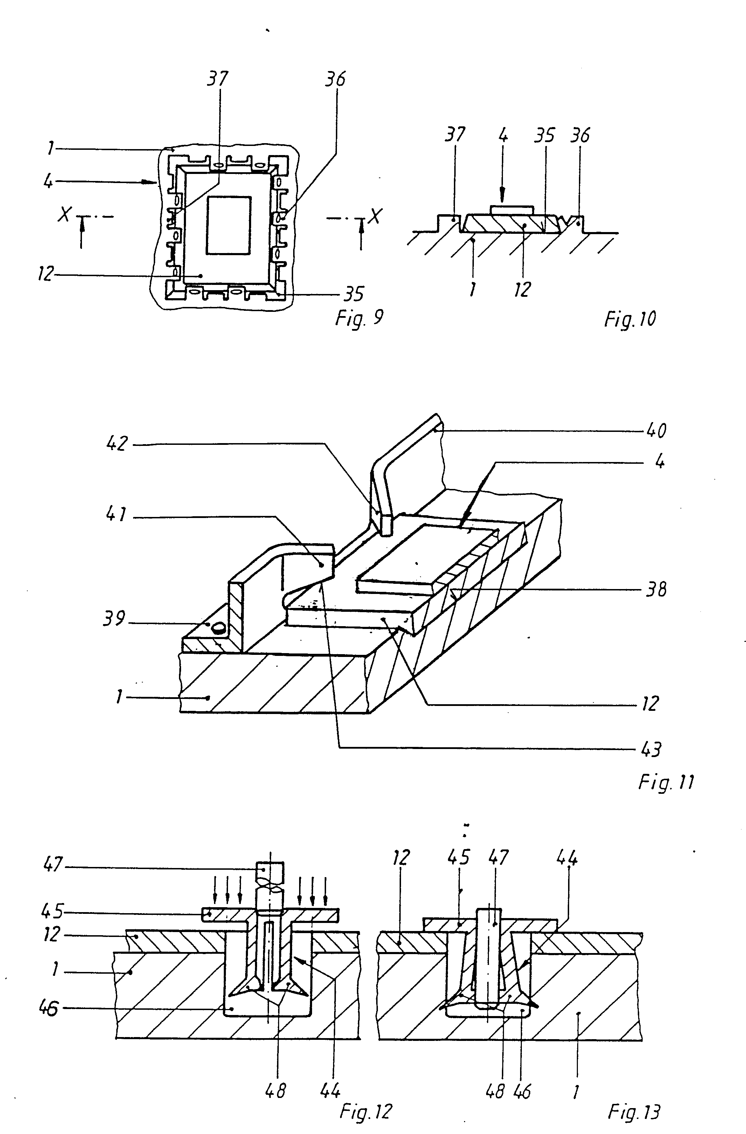

Bei der Ausführungsform gemäß den Figuren 9 und 10 sitzt der Sockel 12 in einer Aufnahmevertiefung 35. Die Trägerplatte 1 hat angegossene Finger, beispielsweise Finger 36, 37. Der Figur 10 ist zu entnehmen, daß der Finger 36 verstemmt ist, so daß er sich gegen den Sockel 12 lehnt. Der andere Finger 37 ist nicht verstemmt. Da insgesamt nur die Hälfte der Finger 36, 37 verstemmt ist, stehen nach einem Ausbau und Wiedereinbau des elektronischen Bauteils 4 die ursprünglich nicht verstemmten Finger 37 zum Verstemmen und damit zum Halten des Sockels 12 zur Verfügung.

Bei der Ausführungsform nach Figur 11 sitzt ein elektronisches Bauteil 4 mit seinem Sockel 12 in einer Zentrierwanne 38 der Trägerplatte 1. Gehalten wird der Sockel 12 innerhalb der Zentrierwanne 38 durch zwei Klemmbleche 39, 40, welche mit jeweils einem abgebogenen Lappen 41, 42 über den Sockel 12 greifen. Diese Lappen 41, 42 weisen zu ihrem freien Ende ansteigende Unterseiten 43 auf. Dadurch werden die Sockel 12 von den Lappen 41, 42 in die Zentrierwanne 38 gepreßt. Da die Klemmbleche 39, 40 aus gehärtetem Material bestehen sollen, vermögen sich die Lappen 41, 42 in die Sockel 12 einzudrücken, so daß ein Formschluß entsteht.

Gemäß den Figuren 12 und 13 sitzt jeweils in einem Loch 46 der Trägerplatte 1 ein gehärteter Spreizdübel 44, welcher einen Rand 45 hat, der sich im montierten Zustand auf die Sockel 12 zweier benachbarter elektronischer Bauteile 4 aufzusetzen vermag. Innerhalb des Loches 46 hat der Spreizdübel 44 schräg nach unten gerichtete Dübelkrallen 48. Dadurch wird eine nach unten gerichtete Zugkraft ausgeübt, sobald der Spreizdübel 44 mittels eines Dorns 47 gespreizt ist, so daß sich der Rand 45 fest auf die Sockel 12 aufsetzt. Zusätzlich drücken sich die Dübelkrallen 48 in die Wandung des Loches 46 ein, was zu einem Formschluß führt.

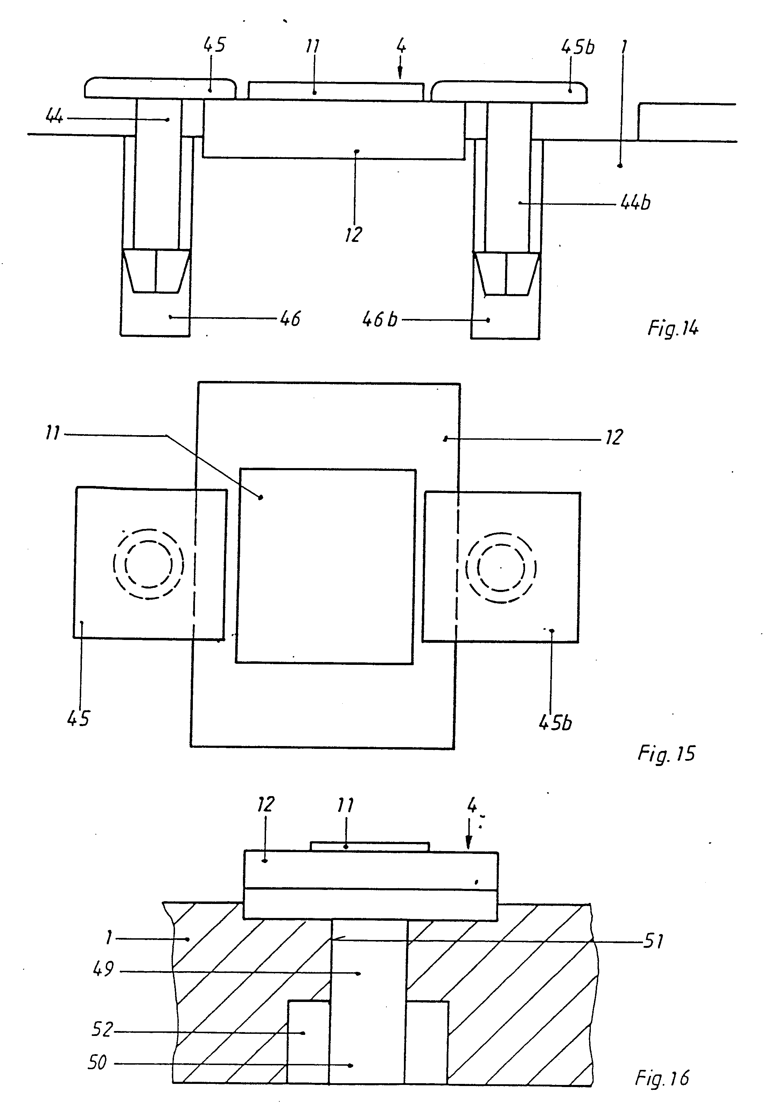

Die Figuren 14 und 15 zeigen, wie die zwei Spreizdübel 44, 44b mit ihrem jeweiligen Rand 45, 45b auf dem Sockel 12 des elektronischen Bauteils 4 aufsitzen und dieses auf diese Weise halten.

Bei der in Figur 16 gezeigten Ausführungsform ist der Sockel 12 des elektronischen Bauteils 4 als Niet 49 ausgebildet, welches mit seinem Schaft 50 durch ein Durchgangsloch 51 der Trägerplatte 1 geführt ist, so daß es auf der dem Chip 11 gegenüberliegenden Seite der Trägerplatte 1 in einer Aufweitung 52 vernietbar ist. Zum Auswechseln des elektronischen Bauteils 4 kann man das Niet 49 ausbohren.

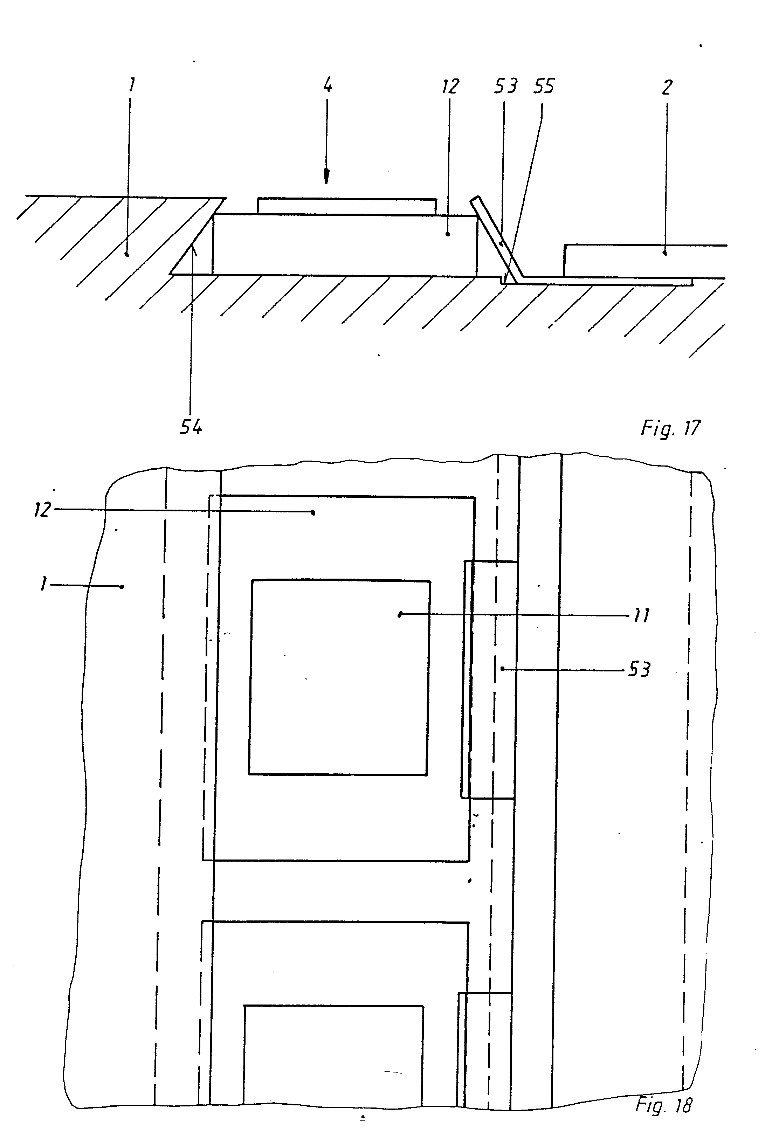

Die Figuren 17 und 18 zeigen ein elektronisches Bauteil 4, dessen Sockel 12 mittels eines Winkelstückes 53 gegen eine schräge Schulter 54 der Trägerplatte 1 gehalten ist. Die Schulter 54 ist derart schräg, daß sie mit ihrer Oberseite weiter zum Sockel 12 hin vorspringt als an ihrer Unterseite. Das Winkelstück 53 besteht aus federndem Material, so daß es den Sockel 12 mit Vorspannung gegen die Schulter 54 drückt. Gehalten wird das Winkelstück 53 dadurch, daß es in einer Ausnehmung 55 sitzt und von dem Hybrid 2 nach oben hin abgedeckt wird.

## Ansprüche

1. Aus Metall bestehende Trägerplatte, auf der mehrere elektronische Bauteile, insbesondere IC's, mit jeweils einem metallischen Sockel aufgesetzt und gehalten sind, dadurch gekennzeichnet, daß die Sockel (12, 20, 22) der elektronischen Bauteile (4, 21, 23) durch teilweise über die Sockel (12, 20, 22) greifende Halteteile (13, 14, 17) der Trägerplatte (1) auf ihr lösbar gehalten sind.

2. Trägerplatte nach Anspruch 1, dadurch gekennzeichnet, daß die Sockel (12, 20, 22) der elektronischen Bauteile (4, 21, 23) in Aufnahmevertiefungen (5 -10) der Trägerplatte (1) eingesetzt sind.

3. Trägerplatte nach den Ansprüchen 1 oder 2, dadurch gekennzeichnet, daß die Aufnahmevertiefungen (5 -10) durch Formpressen erzeugt sind.

4. Trägerplatte nach einem oder mehreren der vorangehenden Ansprüche, dadurch gekennzeichnet, daß die Halteteile (13, 14) durch aus der Ebene der Halteplatte (1) ragende Stege gebildet sind, welche mit jeweils zumindest einer Abbiegung (15, 16) teilweise über die Sockel (12) greifen.

5. Trägerplatte nach einem oder mehreren der vorangehenden Ansprüche, dadurch gekennzeichnet, daß die Aufnahmevertiefungen (10) breiter als die Sockel (12) sind und in ihnen zumindest ein Halteteil (14) eingesetzt ist, welches den aus der Ebene der Halteplatte (1) ragenden Steg aufweist.

6. Trägerplatte nach einem oder mehreren der vorangehenden Ansprüche, dadurch gekennzeichnet, daß die Halteteile in die Halteplatte (1) eingesetzte Federelemente (17) sind, welche mit einem Federarm (18, 19) federnd teilweise über zumindest einen Sockel (20, 22) ragen.

7. Trägerplatte nach einem oder mehreren der vorangehenden Ansprüche, dadurch gekennzeichnet, daß die Federelemente (17) durch in entgegengesetzte Richtungen weisende Federarme (18, 19) zum Halten von jeweils zwei Sockeln (20, 22) augebildet sind.

8. Trägerplatte nach einem oder mehreren der vorangehenden Ansprüche, dadurch gekennzeichnet, daß zwischen der Trägerplatte (1) und den Sockeln (12, 20, 22) der elektronischen Bauteile (4, 21, 23) eine Wärmeleitpaste vorgesehen ist.

9. Trägerplatte nach Anspruch 1, dadurch gekennzeichnet, daß das Halteteil ein brückenförmiges, über jeweils ein Chip (11) greifendes, zu beiden Seiten des Chips (11) auf dem Sockel (12) aufsitzendes Druckstück (24) ist, auf dessen Oberseite sich eine Druckfeder (25) abstützt, die andererseits gegen einen seitlich eines oder mehrerer elektronischer Bauteile (4) lösbar befestigten Balken (26) anliegt.

10. Trägerplatte nach Anspruch 9, dadurch gekennzeichnet, daß der Sockel (12) Fangnasen (27) zur Vorfixierung der elektronischen Bauteile (4) hat.

11. Trägerplatte nach Anspruch 1, dadurch gekennzeichnet, daß die Trägerplatte (1) für jedes elektronische Bauteil (4) jeweils eine länger als das Bauteil (4) ausgebildete Wanne (28) hat und von beiden Seiten her mit Pratzen (29 -31) über den Sockel (12) greift und daß der Sockel (12) zum Einlegen in jeweils eine Wanne (28) im Bereich der Pratzen (29, 31) Aussparungen (33, 34) aufweist.

12. Trägerplatte nach Anspruch 11, dadurch gekennzeichnet, daß die Wannen (28) und entsprechend die Sockel (12) von oben her gesehen trapezförmig ausgebildet sind.

13. Trägerplatte nach Anspruch 1, dadurch gekennzeichnet, daß jeder Sockel (12) in einer Aufnahmevertiefung (35) sitzt und dort durch einzelne, nach Einsetzen des Sockels (12) verstemmte Finger (36, 37) gehalten ist.

14. Trägerplatte nach Anspruch 13, dadurch gekennzeichnet, daß zum Halten des Sockels (12) nur ein Teil der Finger (37) verstemmt ist.

15. Trägerplatte nach Anspruch 1, dadurch gekennzeichnet, daß die Trägerplatte (1) für jedes elektronische Bauteil (4) jeweils eine Zentrierwanne (38) hat und seitlich des Sockels (12) auf der Trägerplatte (1) Klemmbleche (39, 40) mit jeweils einem über den Sockel (12) gebogenen Lappen - (41, 42) angeordnet sind.

16. Trägerplatte nach Anspruch 15, dadurch gekennzeichnet, daß die Lappen (41, 42) jeweils eine schräg verlaufende, zu ihrem freien Ende hin ansteigende Unterseite (43) haben.

17. Trägerplatte nach den Ansprüchen 15 oder 16, dadurch gekennzeichnet, daß pro Sockel (12) doppelt so viele Klemmbleche (39, 40) wie zum Halten des Sockels erforderlich vorgesehen sind und zur Erstbefestigung nur die Lappen (40, 41) jedes zweiten Klemmbleches (39, 40) abgebogen sind.

18. Trägerplatte nach Anspruch 1, dadurch gekennzeichnet, daß das Halteteil ein in ein Loch - (46) der Trägerplatte (1) sitzender Spreizdübel - (44) ist, welcher mit einem Rand (45) über zwei benachbarte Sockel (12) greift.

19. Trägerplatte nach Anspruch 18, dadurch gekennzeichnet, daß der Spreizdübel (44) innerhalb des Loches (46) schräg nach unten gerichtete Dübelkrallen (48) hat.

20. Trägerplatte nach Anspruch 1, dadurch gekennzeichnet, daß der Sockel (12) des elektronischen Bauteils (4) mit einem Niet (49) eine Einheit bildet, dessen Schaft (50) durch ein Durchgangsloch (51) der Trägerplatte (1) hindurchgeführt und auf der dem Chip (11) gegenüberliegenden Seite der Trägerplatte (1) vernietet ist.

21. Trägerplatte nach Anspruch 1, dadurch gekennzeichnet, daß die Halteelemente federnde Winkelstücke (53) sind, welche mit einem schräg gegen jeweils einen Sockel (12) anliegenden Schenkel den Sockel (12) gegen jeweils eine Schulter (54) der Trägerplatte (1) drücken.

22. Trägerplatte nach Anspruch 21, dadurch gekennzeichnet, daß die Schulter (54) zur Oberseite des Sockels hin vorspringt.

Fig. 1

Fig. 2

Fig.3

Fig. 4

Fig. 5

26

25

24

11

12

1

4

27

Fig. 6

33

29

4

30

1

28

31

34

12

32

Fig. 7

30  11  4

32

28  12  1

Fig. 8

37  36

1

4

X — · — — · — X

12

35

Fig. 9

37  4  35  36

1  12

Fig. 10

42

41

39

1

40

4

38

12

43

Fig. 11

47

45

12

1

46

48  44

Fig. 12

12  45  47  44

48  46  1

Fig. 13

0 226 042

Fig.14

Fig. 15

Fig. 16

Fig. 17

Fig. 18